Europäisches Patentamt

European Patent Office

Office européen des brevets

(19)

(11) Publication number: 0 389 087
A2

## (12) EUROPEAN PATENT APPLICATION

(21) Application number: 90301008.0

(51) Int. Cl.⁵: **C11D 7/50, C23G 5/032**

(22) Date of filing: 31.01.90

The title of the invention has been amended (Guidelines for Examination in the EPO, A-III, 7.3).

(30) Priority: 01.02.89 JP 22838/89
06.09.89 JP 231312/89
20.09.89 JP 245835/89

(43) Date of publication of application:
26.09.90 Bulletin 90/39

(84) Designated Contracting States:
AT BE CH DE DK ES FR GB GR IT LI LU NL SE

(71) Applicant: **MITSUI PETROCHEMICAL INDUSTRIES, LTD.**
**2-5, Kasumigaseki 3-chome Chiyoda-ku**
**Tokyo 100(JP)**

Applicant: **HITACHI, LTD.**
**6, Kanda Surugadai 4-chome**
**Chiyoda-ku, Tokyo 101(JP)**

(72) Inventor: **Tsumoto, Takamasa, c/o Mitsui**
**Petrochemical**
**Industries, Ltd., 1-2, Waki 6-chome**
**Waki-cho, Kuga-gun, Yamaguchi(JP)**
Inventor: **Miyake, Hirohiko, c/o Mitsui**
**Petrochemical**
**Industries, Ltd., 2-5, Kasumigaseki 3-chome**
**Chiyoda-ku, Tokyo(JP)**
Inventor: **Takehana, Yohichi**
**4-3-47-7-306, Nishihara**
**Tanashi-shi, Tokyo(JP)**
Inventor: **Saito, Yoshio**
**2-164-8, Chigaze-machi**
**Oume-shi, Tokyo(JP)**
Inventor: **Itoh, Katsuhiko**
**2196-186, Hirai, Hinode-machi**
**Nishitama-gun, Tokyo(JP)**

(74) Representative: **Myerscough, Philip Boyd et al**
**J.A.Kemp & Co. 14, South Square Gray's Inn**
**London, WC1R 5EU(GB)**

(54) Washing agent and method.

(57) A washing agent suitable for use on, for example, substrates usable in the production of semiconductors, containing (a) pentafluoropropanol, (b) a solvent mixture of pentafluoropropanol, and at least one solvent miscible with pentafluoropropanol, or a nonflammable fluoroalkyl alcohol containing hexafluoroisopropanol as a main component.

EP 0 389 087 A2

**WASHING AGENT, WASHING METHOD AND PROCESS FOR PREPARING SEMICONDUCTOR INTEGRATED CIRCUIT DEVICE BY USE THEREOF**

## BACKGROUND OF THE INVENTION

### 1. Field of the Invention

The present invention relates to a washing agent and a washing method, more specifically to a washing agent and washing method effective for washing substrates usable in the production of semiconductors. The present invention also relates to a technique of washing and drying the surface of a material to be treated, and relates to an effective technique of washing and drying a silicone wafer or photomask during, for example, the production of semiconductor integrated circuit devices.

### 2. Description of the Related Art

Substrates such as a wafer used for the production of semiconductors such as an IC and LSI, substrates such as a mask, reticle, and a quartz substrate as a precursor thereof, used in the photolithographic steps, substrates such as glass substrates used during the production of pellicles, and substrates used in the production of stampers used in the production of optical discs, must be washed very clean.

As a method of washing the substrates mentioned above, a vapor washing and drying method is widely used in the prior art in which most of the contamination is removed by a method such as that in which foreign matter adhered to the substrates is removed by ultrasonic or sonication vibration while dipping the substrate in an aqueous detergent solution or ultra-pure water, a method in which friction washing is performed with a brush of PVA foam, using an aqueous detergent solution or ultra-pure water, or a method of removing organic materials through an oxidation reaction by dipping the substrate into a solution of $H_2SO_4$ or $NH_4OH-H_2O_2$ , and then placing the substrate in a washing solvent vapor of isopropyl alcohol or flon (fluorocarbon), whereby the substrate surface is washed by a condensation of the vapor on the substrate surface, and the substrate becomes dry when the temperature of the substrate is equal to that of the vapor.

In the preparation of semiconductor integrated circuit devices, washing and drying treatments are performed at each lithographic step. One such wafer washing and drying method utilizes the vapor of isopropyl alcohol (IPA). This method utilizes the property of IPA, which can be mixed with water at any desired ratio, and the method in which, for example, after the water washing step, a wafer is exposed to a vapor atmosphere of IPA, and water is washed by the IPA condensed on the surface of the wafer, and becomes dry when the temperature of the wafer reaches the vaporizing temperature of the IPA. Also, this method has the advantage in that both a removal of water (drying) and a removal of foreign matter (washing) can be combined, because IPA is an organic solvent and thus can also wash away foreign matter which cannot be removed with water. The washing and drying technique utilizing the vapor of IPA is disclosed in, for example, Japanese Patent Application No. 62-299278 (i.e., JP-A-1-140728).

Nevertheless, when isopropyl alcohol is used in the above-mentioned vapor washing and drying method, because isopropyl alcohol is inflammable, (i.e., an ignition temperature of 11.7° C and an explosion concentration in the air of 2-12 vol%), a problem arises in that accidents such as a fire or explosion are liable to occur. Also, currently there is a movement to suppress the use of flon (fluorocarbon).

## SUMMARY OF THE INVENTION

Accordingly, the objects of the present invention are to eliminate the above-mentioned disadvantages of the prior art and to provide a safe washing agent and a washing method which does not use flon (fluorocarbon), but has washing and drying characteristics equal to or better than those obtained when isopropyl alcohol or flon (fluorocarbon) is used.

Another object of the present invention is to provide a highly efficient washing and drying of a material to be treated, while at the same time accomplishing the above-mentioned object of the present invention.

Other objects and advantages of the present invention will be apparent from the following description.

In accordance with the present invention, there is provided a washing agent comprising pentafluoropropanol or hexafluoroisopropanol or a solvent mixture thereof and at least one solvent miscible therewith.

In accordance with the present invention, there is also provided a washing method comprising washing a material to be washed by placing it in a vapor of pentafluoropropanol or hexafluoroisopropanol or a solvent mixture thereof, with at least one solvent miscible therewith.

In accordance with the present invention, there is further provided a washing agent comprising a nonflammable fluoroalkyl alcohol containing hexafluoroisopropanol as a main component.

In accordance with the present invention, there is further provided a washing and drying method of removing water and foreign matter attached to the surface of a material to be treated, which comprises exposing said material to be treated to the vapor atmosphere of a solvent comprising a nonflammable fluoroalkyl alcohol containing hexafluoroisopropanol as the main component.

In accordance with the present invention, there is further provided a process for preparing a semiconductor integrated circuit device, which comprises washing and drying a semiconductor wafer by the above-mentioned washing and drying method in the prewashing step during a formation of a predetermined integrated circuit pattern through a resist pattern formed on the main surface of said semiconductor wafer, or in the washing step after removal of said resist pattern.

In accordance with the present invention, there is further provided a process for preparing a semiconductor integrated circuit, which comprises washing and drying a photomask by the above-mentioned washing and drying method during preparation of the photomask having a predetermined integrated circuit pattern in the washing step of the photomask after removal of said resist pattern by effecting etching of a light shielding film through the resist pattern formed on the main surface of a glass substrate having said light shielding film provided thereon.

## BRIEF DESCRIPTION OF THE DRAWINGS

The present invention will be better understood from the description set forth below with reference to the accompanying drawings, wherein:

Figure 1 is a view of one embodiment of a vapor washing and drying device according to the present invention; and

Fig. 2 is a sectional view of the washing and the drying device used in the Examples 3 to 7 of the present invention.

## DESCRIPTION OF THE PREFERRED EMBODIMENTS

The material to be washed in the present invention is not particularly limited, provided that it is formed of a material stable to a washing agent (e.g., pentafluoropropanol and others), and the agent and this method are particularly suitable for washing a substrate. As the substrate, glass, quartz, and those having a coating of chromium formed on the surfaces thereof by vapor deposition, a resin, or those having a circuit pattern formed thereon are included. Specific examples of such substrates include substrates such as a wafer used in the production of semiconductors, substrates such as a mask, reticles, and quartz substrates as the precursor thereof, etc., substrates such as glass substrates used during the production of pellicles, and substrates used for the production of stampers used in the production of optical discs.

The pentafluoropropanol used as the washing solvent in the washing and drying method of the present invention is nonflammable, and thus there is no danger of fire or explosion, and is nontoxic and can be naturally decomposed, and therefore, there is no fear of inducing environmental problems even when diffused in the air. The physical properties of pentafluoropropanol are shown in Table 1.

Table 1

Molecular formula: $CF_3CF_2CH_2OH$
Molecular weight: 150.0
Boiling point: 354 K
Critical temperature: 498 K
Critical pressure: 3.62 MPa
Critical specific volume: 0.00191 $m^2/kg$
Thermal conductivity: 0.0956 W/m·K (298 K)
Viscosity: 0.00282 Pa·s (298 K)
Azeotropic mixture: $CF_3CF_2CH_2OH/H_2O$ 94/6 % by weight

Toxicity:
Nontoxic
Inhalation ALC 6800 ppm
Oral: LD 762 mg/kg
Combustibility: Nonflammable

As other solvents constituting the washing agent of the present invention, any solvent (excluding halogenated hydrocarbons) miscible with pentafluoropropanol or hexafluoroisopropanol can be used, and include water, alcohols, ethers, esters, ketones, and hydrocarbons.

Examples of the alcohols include methanol, ethanol, propanol, isopropanol, butanol, sec-butanol, tert-butanol, ethylene glycol, propylene glycol, trimethylene glycol, 1,2-butane diol, 1,3-butane diol, 1,4-butane diol, 2,3-butane diol, isobutylene glycol, benzyl-alcohol, cinnamyl alcohol, cyclopentanol, cyclohexanol, and the like.

Examples of the ethers include propyl ether, butyl ether, ethylene glycol monomethyl ether, ethylene glycol monoethyl ether, ethylene glycol diethyl ether, dioxane, and the like.

Examples of the esters include methyl acetate, ethyl acetate, n-propyl acetate, isopropyl acetate, n-butyl acetate, isobutyl acetate, sec-butyl acetate and the like.

Examples of the ketones include dimethyl ketone, ethyl methyl ketone, diethyl ketone, methyl propyl ketone, isopropyl methyl ketone, butyl methyl ketone, ethyl propyl ketone, isobutyl methyl ketone, methyl n-hexyl ketone, methyl n-amyl ketone, ethyl n-butyl ketone, di-n-propyl ketone, diisobutyl ketone, dimethyloxide, phorone, isophorone, cyclohexanone, methylcyclohexanone, actophenone, and the like.

Examples of the hydrocarbons include hexane, heptane, octane, benzene, toluene, ethylbenzene, propylbenzene, isopropylbenzene, n-butylbenzene, isobutylbenzene, sec-butylbenzene, tert-butylbenzene, xylene, ethylmethylbenzene, diethylbenzene, cyclohexane, and the like.

Particularly, when washing with the vapor as described below, preferably a solvent having a higher boiling point than that of pentafluoropropanol or hexafluoroisopropanol is used.

The mixing ratio of pentafluoropropanol or hexafluoroisopropanol and another solvent, if used, depends on the material to be washed and the washing method, and is preferably 50% or more of pentafluoropropanol or hexafluoroisopropanol in terms of weight ratio.

As the washing method using the washing agent of the present invention, general washing methods such as dipping a material to be washed in a washing agent or spraying a washing agent onto a material to be washed can be employed, but particularly preferably a method is employed in which a material to be washed is placed in the vapor of a washing agent, to clean the surface of the material, followed by drying.

As the specific washing method, most contamination is removed by a pre-treatment method similar to that of the prior art methods, including the method in which foreign matter adhered to the substrate is removed by ultrasonic vibration while dipping the substrate into an aqueous detergent solution or ultra-pure water, the method in which friction washing is performed with a brush of PVA foam, using an aqueous detergent solution or ultra-pure water, or the method of removing organic materials through an oxidation reaction by dipping the substrate into a solution of $H_2SO_4$ or $NH_4OH-H_2O_2$ , and then placing the substrate in the vapor of pentafluoropropanol or hexafluoroisopropanol, whereby the substrate surface is washed by a condensation of the vapor on the substrate surface, and the substrate becomes dry when the temperature of the substrate is equal to that of the vapor, thus completing the washing and drying process.

Referring now to the drawing, an embodiment of the washing and drying method of the present invention is described.

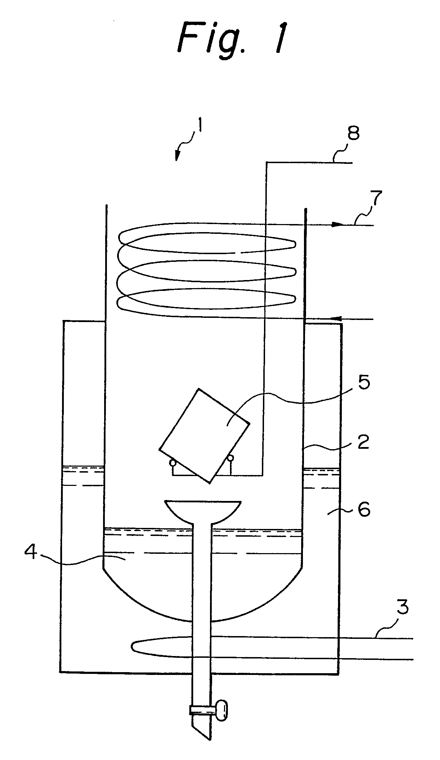

Figure 1 is a view of a vapor washing and drying device 1, in which 2 is a washing tank, 3 a heater, 4 pentafluoropropanol, 5 a substrate, 6 a heating medium, 7 cooling water, and 8 a support. The washing tank 2 is filled with vapor of, for example, pentafluoropropanol 4, which is the washing solvent, obtained by heating the heating medium 6 by the heater 3. When the pre-treated substrate 5 is placed in the washing tank 2, since the temperature of the substrate 5 is lower than the temperature of the vapor of the pentafluoropropanol 4, pentafluoropropanol 4 is condensed and liquefied on the surface of the substrate 5, and the substrate 5 surface is washed with the liquefied pentafluoropropanol 4.

Then the temperature of the substrate 5 is raised, whereby the amount of condensed pentafluoropropanol 4 is reduced, until no condensation occurs when the temperature of the substrate 5 and the temperature of the vapor of pentafluoropropanol 4 are the same, whereby the substrate 5 becomes dry. The vapor of the pentafluoropropanol 4 is prevented from dissipation from the washing tank 2 by the cooling water 7.

No pentafluoropropanol, which is the washing solvent, remains on the thus washed and dried surface of the substrate 5, and further, the time required for drying after washing is short, whereby drying can be effected within a short time.

According to the present invention, since pentafluoropropanol or hexafluoroisopropanol is used as the washing solvent in the method of washing and drying a substrate, no flon is used, and the danger of fire or explosion, which poses a problem when using isopropyl alcohol as the solvent in the method of the prior art can be avoided, and further, the washing and drying of a substrate by the present method is equal to or better than that of the method of the prior art.

According to another embodiment of the present invention, since a solvent mixture comprising pentafluoropropanol or hexafluoroisopropanol and another solvent is used as the washing solvent, a stronger washing force than in the case of pentafluoropropanol or hexafluoroisopropanol alone can be obtained.

In the second aspect of the present invention, a nonflammable fluoroalkyl alcohol containing hexafluoroisopropanol is used as a washing agent. Since hexafluoroisopropanol is highly compatible with water, it can quickly replace the water on the surface of a material to be treated, as does the IPA of the prior art. Also, while the evaporation latent heat of IPA is 9.6 Kcal/mol, that of hexafluoroisopropanol is 8.7 Kcal/mol, and therefore, the drying efficiency is higher than IPA. Further, while the surface tension of IPA is 22 dyn/cm, that of hexafluoroisopropanol is 17 dyn/cm. Namely, hexafluoroisopropanol has a greater wettability with the surface of a material to be treated than IPA, and therefore, the foreign matter washing efficiency is higher than in the prior art method using IPA.

The boiling point of hexafluoroisopropanol is 58.6 °C, which is lower than the boiling point 82.4 °C of IPA, and therefore, when the installation of the prior art is utilized as such, the setting of the temperature of the heater must be changed. It is also possible to use the setting of the installation of the prior art as such by adding pentafluoropropanol (boiling point 80.6 °C) or 1,1,5-trihydrooctafluoropentanol (boiling point 140 °C), which has a higher boiling point than hexafluoroisopropanol but is nonflammable and has less solubility in water. Further, generally speaking, mixing a solvent having a higher boiling point than that of hexafluoroisopropanol is preferable for enhancing the drying efficiency of hexafluoroisopropanol.

Trifluoroethanol and 1,1,3-trihydrotetrafluoropropanol, which have higher boiling points than hexafluoroisopropanol, can be used for enhancing the drying efficiency, but since both are ignitable, they are preferably used in amounts which will not raise the danger of fire.

More specifically, when a mixture of hexafluoroisopropanol with another solvent is utilized, the proportions thereof depend on the material to be washed and the washing method, but preferably the nonflammable fluoroalkyl alcohol is used in an amount of 50% or more in terms of weight ratio. The inflammable solvent is preferably used in an amount such that there is no danger of fire.

As other solvents constituting the washing agent of the present invention, any solvent miscible with the fluoroalkyl alcohol can be used, including water, as well as the above-mentioned alcohols, ethers, esters, ketones, and hydrocarbons.

Examples of the halogenated hydrocarbons include dichloromethane, tetrachloromethane, trichloroethylene, tetrachloroethylene, chlorobenzene, dichlorobenzene, trichlorobenzene, and the like.

As the washing method using the washing agent of the present invention as described above, washing methods such as dipping a material to be washed in the washing agent or spraying the washing agent onto a material to be washed can be employed, but preferably the method of placing a material to be washed in the vapor of the washing agent to clean the surface of a material to be washed, followed by drying, is used.

Of the inventions disclosed in the present application, outlines of representatives thereof are briefly given as follows.

The first invention of the present application is a washing agent comprising a nonflammable fluoroalkyl alcohol containing hexafluoroisopropanol as the main component.

The second invention is a washing and drying method of removing water and foreign matter attached to the surface of a material to be treated, which comprises exposing the above material to be treated to a vapor atmosphere of a solvent comprising a nonflammable fluoroalkyl alcohol containing hexafluoroisopropanol as the main component.

## EXAMPLES

The present invention will now be further illustrated by, but is by no means limited to, the following Examples.

### Example 1

Using pentafluoropropanol as the washing solvent, a glass substrate for a reticle was washed and dried, and the washed and dried state and the draining of the substrate were visually observed. The substrate was pre-washed with sulfuric acid (120°C x 5 min.), followed by water washing (5 min.) and water ultrasonic washing (3 min.). The results are shown in Table 2.

Comparative Examples 1 and 2

Using isopropyl alcohol (Comparative Example 1) or flon (fluorocarbon) (Comparative Example 2), the same procedure as in Example 1 was repeated. The results are shown in Table 2.

Example 2

Using a solvent mixture of 90% by weight of pentafluoropropanol and 10% by weight of isopropanol as the washing solvent, a glass substrate for a reticle was washed and dried, and the washed and dried state and the draining of the substrate were visually observed. The substrate was pre-washed with sulfuric acid (120°C x 5 min.), followed by water washing (5 min.) and water ultrasonic washing (3 min.). The results are shown in Table 2.

Table 2

| Example No. | Washing solvent | Draining state | Washed and dried state |
|---|---|---|---|
| Example 1 | Pentafluoropropanol | Good | Good |
| Example 2 | Pentafluoropropanol (90) + Isopropanol (10) | Good | Good |
| Comparative Example 1 | Isopropyl alcohol | Good | Good |
| Comparative Example 2 | flon | Common | Partial staining occurred |

From the results shown in Table 2, it can be understood that pentafluoropropanol or the solvent mixture of pentafluoropropanol, which is nonflammable and nontoxic has a drying characteristic and non-remaining characteristic equal to or better than those of the isopropanol or flon of the prior art.

Example 3

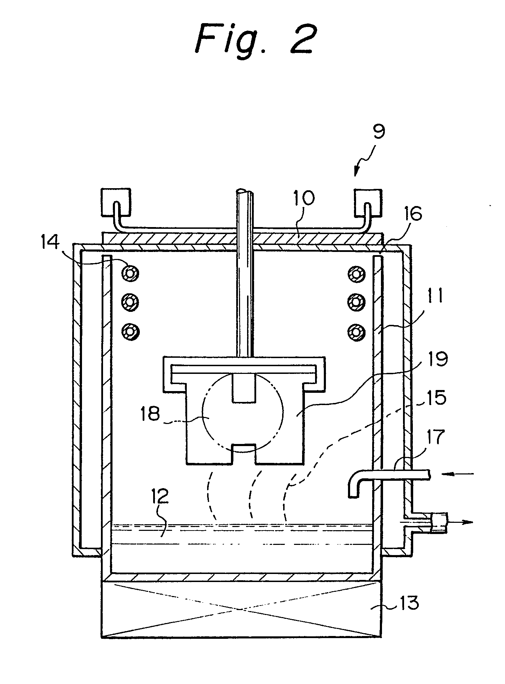

Figure 2 shows the washing and drying device used in this Example. In the Figure, the washing and drying device 9 comprises a vessel 11 equipped with an openable shutter plate 10 at an upper part thereof. A solvent 12 of nonflammable fluoroalkyl ether, or comprising same as the main component, is stored at the bottom of the vessel 11. The solvent 12 is heated to boiling point by the heater 13 provided at the lower surface of the bottom of the vessel 11. At the upper part within the vessel 11, a cooling pipe arranged in spiral shape along the side wall thereof is provided. Cooling water is circulated within the cooling pipe so that the vapor 15 of the boiled solvent 12 is condensed by contact with the cooling pipe 6 and falls onto the bottom of the vessel 11. An evacuation outlet 16 for discharging the vapor 15 within the vessel 11 is provided between the upper end portion of the vessel 11 and the shutter plate 10. At the bottom side wall is provided a feeding inlet 17 for feeding the solvent 12, to enable a supplement and exchange thereof. The material 18 to be treated, such as a semiconductor wafer or photomask, is washed with pure water, suspended within the vessel 11 while housed in the implement 19, and exposed to the vapor 15 of the boiled solvent 12 while in this state.

The method of washing and drying semiconductor wafer is now described. Specifically, this is a washing and drying method applied to the pre-washing step during the formation of an integrated circuit pattern through a resist pattern formed on the main surface of a semiconductor wafer. The solvent is hexafluoroisopropanol. The solvent has a boiling point of 58.6°C, which is considerably lower than that (82.4°C) of IPA, but the washing and drying device of the prior art using IPA as the solvent can be used as such, and the setting of the heater 5 adjusted before use.

First, after a wafer 14 inches in diameter was treated with an aqueous hydrofluoric acid solution, the aqueous hydrofluoric acid solution attached to the surface thereof was thoroughly washed away with pure water at 20° C. Further, the vessel of the washing and drying device was filled with the vapor of vigorously pre-boiled hexafluoroisopropanol . The above wafer having water attached thereto was conveyed into the vessel while housed in the implement, and washed and dried by exposure to the vapor of hexafluoroisopropanol while stationary, as shown in Fig. 2, for 10 minutes. When the surface of the wafer was examined by a foreign matter examination means, no foreign matter was detected.

Example 4

Example 4 is a washing and drying method applied to the washing step after removal of the resist pattern formed on the main surface of a semiconductor wafer. The solvent used in Example 4 is a solvent mixture of hexafluoroisopropanol and pentafluoroisopropanol.

First, on the main surface of the wafer pre-washing by the method of Example 3, a polysilicon film was coated by the CVD method. Next, a photoresist film was coated on the surface of the polysilicon film, and after formation of a predetermined resist pattern by exposure and development, the polysilicon film was dry etched through the resist pattern. Next, subsequent to oxygen ashing, the resist pattern on the wafer surface was removed by a chemical solution treatment and the chemical solution on the surface of the wafer was then thoroughly washed away with pure water. Further, the vessel of the washing and drying device was filled with the vapor of the vigorously preboiled fluoroalkyl alcohol. The above wafer having water attached thereto was conveyed into the vessel while housed in the implement, and washed and dried by exposure to the vapor of the fluoroalkyl alcohol while stationary, as shown in Fig. 2, for 10 minutes. When the surface of the wafer was examined by a foreign matter examination means, no foreign matter was detected.

Example 5

Example 5 is a washing and drying method applied to the washing step after formation of an integrated circuit pattern on the main surface of a photomask. The solvent used in this Example 5 is the same hexafluoroisopropanol as used in Example 3, and the drying device shown in Fig. 1 was used.

First a quartz glass 14 inch square (mask blanks) and coated with a light shielding film of Cr (chromium) on the main surface was coated with an electron beam resist, and a predetermined integrated circuit pattern was drawn by an electron beam drawing device. After development, the Cr film was etched with a cerium ammonium nitrate solution to prepare a photomask having a predetermined integrated circuit pattern. To remove the resist pattern remaining on the surface of the photomask, subsequent to oxygen ashing, a chemical solution treatment with ozone sulfuric acid was conducted. Then the chemical solution attached to the surface of the photomask was thoroughly washed away with pure water at 30° C. The vessel of the washing and drying device was filled with the vapor of vigorously preboiled hexafluoroisopropanol. The wafer to which water was attached was conveyed into the vessel while housed in the implement, and washed and dried by exposure to the vapor of hexafluoroisopropanol while stationary, as shown in Fig. 2, for 10 minutes. When the surface of the wafer was examined by a foreign matter examination means, no foreign matter was detected on the pattern surface or the glass surface.

Example 6

Example 6 is a washing and drying method applied to the washing step after preparation of a photomask as in Example 5. The solvent used in Example 6 is a solvent mixture of 1,1,5-trihydro-octafluoropentanol and hexafluoroisopropanol. Since 1,1,5-trihydro-octafluoropentanol has little solubility in water, a solvent mixture was prepared with an addition of hexafluoroisopropanol having a larger solubility in water. Also, since 1,1,5-trihydro-octafluoropentanol has a boiling point as high as 141° C, the setting of the heater 13 was adjusted in the above-mentioned washing and drying device 9 shown in Fig. 2.

First after an integrated circuit pattern was formed on the main surface of a photomask by the same method as in Example 5, to remove the resist pattern remaining on the surface of the photomask, subsequent to oxygen ashing, a chemical solution treatment with ozone sulfuric acid was conducted. Then the chemical solution attached to the surface of the photomask was thoroughly washed away. The vessel of the washing and drying device was filled with the vapor of the solvent mixture of 1,1,5-trihydro-octafluoropentanol and vigorously pre-boiled hexafluoroisopropanol. The above-mentioned photomask to which water was attached was conveyed into the vessel of the washing and drying device while housed in the implement, and washed and dried by exposure to the vapor of the solvent mixture while stationary, as shown in Fig. 2, for 10 minutes. When the surface of the photomask was examined by a defect examination means and a foreign matter examination means, no foreign matter was detected on either the pattern surface or the glass surface.

Example 7

Example 7 is a washing and drying method applied to the preparation step of a pellicle film to be mounted on a photomask (reticle) for a reduced projection exposure. The solvent used was the same hexafluoroisopropanol as in Example 3, and the washing and drying device as shown in Fig. 2 was used.

First, after a solution of nitrocellulose dissolved in an organic solvent was added dropwise on the main surface of a quartz glass, the quartz glass was rotated at high speed and a nitrocellulose film (pellicle film) with a film thickness of 865 μ was formed on the surface thereof. After the nitrocellulose film was peeled off, the quartz glass was washed with a chemical solution. Then the chemical solution attached to the quartz glass was thoroughly washed away with pure water at 20°C. The vessel of the washing and drying device was filled with the vapor of vigorously pre-boiled hexafluoroisopropanol. The above quartz glass to which water was attached was conveyed into the vessel while housed in the implement, and washed and dried by exposure to the vapor of hexafluoroisopropanol while stationary, as shown in Fig. 2. When the surface of the wafer was examined by a foreign matter examination means, no foreign matter was detected on either surface thereof.

Although the present invention accomplished by the present inventors is specifically described by referring to the Examples, the present invention is not limited to Examples 3 to 7 as described above, and various modifications are possible without departing from the spirit thereof.

For example, additives may added to the fluoroalkyl alcohol of the present invention, to improve the wettability or the foreign matter washing efficiency on the material to be treated.

In the above Examples, although a description was given of the case wherein the present invention was applied to the washing and drying of a wafer or a photomask, it can be also applied to the washing and drying of an implement such as cassette.

In the above description, although the present invention is applied to the production of semiconductor integration circuit devices, it is not limited thereto, and the present invention can be also applied to the washing and drying of a magnetic disc.

As explained in Examples 3 to 7, according to the present invention, the following effects can be obtained.

(1) Using a solvent comprising a nonflammable fluoroalkyl alcohol containing hexafluoroisopropanol as the main component, when exposing a material to be treated to the vapor atmosphere of a solvent, the danger of fire or explosion during working can be eliminated. Also, the cost of coping with safety enforcements to prevent these dangers is reduced.

(2) Using the above-mentioned fluoroalkyl alcohol (or a mixture thereof), the washing efficiency and the drying efficiency are improved compared with the prior art technique using IPA, whereby the washing and drying time of the material to be treated can be shortened. Also, the degree of cleaning of the surface of the material to be treated is improved.

**Claims**

1. A washing agent comprising pentafluoropropanol or hexafluoroisopropanol.

2. A washing agent comprising a solvent mixture of pentafluoropropanol or hexafluoroisopropanol and at least one solvent miscible therewith.

3. A washing agent as claimed in claim 2, wherein said solvent is at least one compound selected from the group consisting of water, alcohols, ethers, esters, ketones, and hydrocarbons.

4. A washing method comprising washing a material to be washed by placing it in a vapor of pentafluoropropanol or hexafluoroisopropanol or a solvent mixture thereof with at least one solvent miscible therewith.

5. A washing agent comprising a nonflammable fluoroalkyl alcohol containing hexafluoroisopropanol as a main component.

6. A washing agent as claimed in claim 1, wherein the nonflammable fluoroalkyl alcohol is at least one compound selected from the group consisting of pentafluoropropanol, 1,1,5-trihydrooctafluoropentanol.

7. A washing and drying method of removing water and foreign matter attached to the surface of a material to be treated, which comprises exposing said material to be treated to the vapor atmosphere of a solvent comprising a nonflammable fluoroalkyl alcohol containing hexafluoroisopropanol as the main component.

8. A process for preparing a semiconductor integrated circuit device, which comprises washing and drying a semiconductor wafer by the washing and drying method according to claim 7 in the prewashing step during a formation of a predetermined integrated circuit pattern through a resist pattern formed on the main surface of said semiconductor wafer, or in the washing step after removal of said resist pattern.

9. A process for preparing a semiconductor integrated circuit, which comprises washing and drying a photomask by the washing and drying method according to claim 7 during preparation of the photomask having a predetermined integrated circuit pattern in the washing step of the photomask after removal of said resist pattern by effecting etching of a light shielding film through the resist pattern formed on the main surface of a glass substrate having said light shielding film provided thereon.

Fig. 1

# Fig. 2